# EUROPEAN PATENT APPLICATION

(11) **EP 3 730 933 A1**
(43) Date of publication of application: **28.10.2020**
(21) Application number: 19382312.7
(22) Date of filing: 24.04.2019
(51) Int. Cl.: G01N 27/414, H01L 29/772, H01L 51/05

(54) **AN ELECTROLYTE-GATED FIELD-EFFECT TRANSISTOR WITH SURFACTANT LAYER**

(71) Applicant: Consejo Superior De Investigaciones Científicas, 28006 Madrid (ES)
(72) Inventor: MAS TORRENT, Marta, 08193 Cerdanyola del Vallès (Barcelona) (ES); LEONARDI, Francesca, 08193 Cerdanyola del Vallès (Barcelona) (ES); ZHANG, Qiaoming, 08193 Cerdanyola del Vallès (Barcelona) (ES)
(74) Representative: Pons

(57) **Abstract**

The present invention relates to electrolyte-gated field-effect transistor (EGFET) which comprises a layer of surfactant disposed between the organic semiconductor layer and the dielectric layer (electrolyte aqueous solution) which improves the stability of said EGFET, and its method for obtaining by different deposition techniques, and its uses in different diagnostic, biochemical sensor devices. The present invention relates to field-effect transistors, and biosensors devices.

## Description

The present invention relates to electrolyte-gated field-effect transistor (EGFET) which comprises a layer of surfactant which improves the stability of said EGFET, and its method for obtaining by different deposition techniques, and its uses in different diagnostic, biochemical sensor devices. The present invention relates to field-effect transistors, and biosensors devices.

### BACKGROUND ART

Point-of-Care (POC) biosensors are integrated diagnostic devices that allow the detection of clinically relevant biomarkers in biological fluids outside conventional laboratories. The common features of POC tests are that they make diagnostics faster, cheaper and even more efficient, thus facilitating an earlier diagnosis and prompt treatment. POC panorama encompasses a wide range of biological phenomena, such as diabetes, coagulation, heart-attack, pregnancy, infections, food pathogens, drug abuse etc., and, hence, many market opportunities are open. In this framework, cheap organic printable electronics can provide a new generation of POC sensors that would respond such societal needs towards the development of simple and disposable devices that do not require specialized personnel.

Low-cost electronics is becoming a truly transforming, emerging technology with great advantages linked to large area processing and at low cost, with modest energy consumption and on flexible substrates. Transistors are the main components used in electronics, where they function as a switch or amplifier. In particular, wide ranging opportunities for field-effect transistors (FETs) are open in sensing applications since they can offer high sensitivity in addition to the above-mentioned advantages. Further, FETs can also provide a multi-parametric response to changes in the environment. In particular, electrolyte-gated field-effect transistors (EGFETs) represent one of the latest breakthroughs. EGFET layout consists of exposing directly the semiconductor towards an aqueous media which acts as a dielectric. Since these devices can operate in water, they can be directly adapted for the development of biochemical sensors.

However, despite their high potential as sensing platforms in the field of diagnosis and healthcare, some unsolved problems are actually hindering their technological transfer mainly related to their limited electrical stability, which makes them poorly reliable.

### SUMMARY OF THE INVENTION

The present invention discloses an electrolyte-gated field-effect transistor (EGFET) which comprises a surfactant protective layer just above the semiconductor layer.

The use of surfactants, that is, molecules which bear a hydrophilic head and a hydrophobic tail, are importantly contributing to the stabilization of the device during operation due to the formation of a layer on top of the active material. This protecting layer contributes to lowering the water and ion penetration within the semiconductor.

A first aspect of the present invention relates to an electrolyte-gated field-effect transistor which comprises
- a substrate
- two metallic electrodes, one electrode configured to work as source (S) electrode and the other electrode configured to work as drain (D) electrode;
- at least one layer of a semiconductor as active material deposited on the substrate, contacting the two electrodes;
- a dielectric layer formed by an electrolyte aqueous solution situated above the active material;
- a third electrode in contact with the dielectric layer and configured to work as gate electrode, wherein preferably said gate electrode is formed by a conducting electrode selected from Au, Pt, glassy carbon and any combination thereof;
   characterized in that the transistor further comprises a layer of a surfactant disposed between the semiconductor layer and the dielectric layer. Wherein said electrolyte aqueous solution is in contact with the active material through the surfactant layer.

In a preferred embodiment of the electrolyte-gated field-effect transistor, the source electrode and the drain electrode are right above the substrate and the semiconductor is right above the substrate and the source electrode and the drain electrode.

In another embodiment of the electrolyte-gated field-effect transistor, the semiconductor is right above the substrate, and the source electrode and the drain electrode are right above the semiconductor layer.

The consequence of the contact between the surfactant layer and the semiconductor layer is the adsorption of surfactant molecules on the semiconductor surface.

The surfactant layer is configured to be at the interface semiconductor/electrolyte in such a way that it physisorbs on the semiconductor surface making possible that the electrolyte does not interact with the semiconductor and the life time of the device or the transistor is increased. The advantages of the existence of said surfactant layer on the device are:
- Improving the stability of the EGFETs making it possible to continuously operate the device during more than 12 hours without losing its performance in case of p-channel devices whereas up to 2.5 hours for n-channel devices;
- capability of sensors that comprises the transistor of the present invention operating in aqueous environment; and
- long time recording of analytes.

Optionally at least two projections of each electrode S defining a cavity and at least one projection of the electrode D arranged in the cavity of the electrode S or the other way around.

Thus, in a preferred embodiment of the present invention, the layer of the surfactant has a thickness of between 1 nm and 100 nm.

In another preferred embodiment of the present invention, the substrate is selected from Si/SiO₂ substrate, polyethyleneterephtalate, polyethylene naphthalate, polyimide and any combination thereof, preferably the polyamide is poly-oxydiphenylene-pyromellitimide.

In another preferred embodiment of the present invention, the source or drain electrodes are formed by a metal selected from Cr, Au, Pt, Ti, Ag and any combination thereof.

In another preferred embodiment of the present invention, the semiconductor is an inorganic semiconductor selected from C, Si, Ge, Sn, B, Al, Ga, In, N, P, As, Sb, Bi, GaAs, AIGaAs, InGaAl, InSnO, ZnO, TiO₂, SrTiO₃, an amorphous oxide semiconductor and any combination thereof, preferably the amorphous oxide semiconductor is ZnSnO, InGaZnO or InZnO.

In another preferred embodiment of the present invention, the semiconductor is formed by at least one organic semiconductor selected from a p-type or n-type, preferably the p-type organic semiconductor is selected from the list comprising 2,8-Difluoro-5,11-bis(triethylsilylethynyl)anthradithiophene, 6,13-Bis(triisopropylsilylethynyl)pentacene, tetrathiafulvalene, [1]benzothieno[3,2-b][1]benzothiophene (BTBT) and any combination thereof; and the n-type organic semiconductor is selected from the list comprising N,N'-bis(n-octyl)-x:y,dicyanoperylene-3,4:9,10-bis(dicarboximide), PNDI(2OD)2T, fullerene and any combination thereof. More preferably the organic semiconductor is the p-type.

The term "p-type organic semiconductor" as used herein refers to any semiconductor wherein transport of electric charge takes place through the holes. P-type organic semiconductors have been much more studied due to their higher stability in ambient conditions. The term "n-type organic semiconductor" as used herein refers to any semiconductor wherein transport of electric charge takes place by free electrons. N-type organic semiconductors are less developed since their stability is much lower when they are exposed to oxygen and water. Thus, EGFETs based on n-type organic semiconductors are highly unstable and have hardly been reported.

In a more preferred embodiment, the semiconductor layer further comprises an insulating polymer selected from polystyrene or polymetylmethacrylate and any combination thereof which have a molecular weight of between 1000 g/mol and 300000 g/mol.

In another preferred embodiment of the present invention, further comprises a polymeric pool placed on the top of the surfactant layer, wherein said pool is configured to confining the dielectric layer formed by the aqueous electrolyte solution. A further embodiment of the present invention provides the polymeric pool is formed by a polymer selected from polydimethylsiloxane, any polymeric wax and any combination thereof.

In another preferred embodiment of the present invention, further comprises a microfluidic channel placed on the top of surfactant layer configured to contact the dielectric layer with the surfactant layer, decreasing the quantity of electrolyte aqueous solution.

The term "microfluidic channel" as used herein refers to a chamber that can be made of different materials such as plastic, glass or silicon, that geometrically constrains the aqueous electrolyte solution.

In another preferred embodiment of the present invention, the surfactant is an anionic surfactant or cationic surfactant, preferably said anionic surfactant is selected from sodium dodecyl sulfate, sodium octyl sulfate, sodium nonanoyloxybenzenesulfonate and any combination thereof, and wherein said cationic surfactant is selected from hexadecyltrimethylammonium bromide, dimethyldioctadecylammonium bromide, C8-10 alkyl hydroxyethyl dimethylammonium chloride and any combination thereof. In a more preferably embodiment, the surfactant is sodium dodecyl sulfate.

The anionic surfactants that are able to organize on top of an organic semiconductor. In particular, due to their negative charge the 'stability effect' of these molecules is mainly visible on p-type organic semiconductors whereas for n-type semiconductors, a cationic surfactant such as CTAB is required.

In case of recording a transfer characteristic the presence of this additional layer is visible in terms of curve shifting (Vth shift).

These molecules of surfactant can create a protective auto-assembled layer on top of the semiconductor preventing the electrolyte penetration within the thin film and improving its stability during long time recording.

The term "surfactant" as used herein refers to compounds that lower the surface tension (or interfacial tension) between two liquids, between a gas and a liquid, or between a liquid and a solid. Surfactants are usually organic compounds that are amphiphilic, meaning they contain both hydrophobic groups (their tails) and hydrophilic groups (their heads). Therefore, a surfactant contains both a water-insoluble (or oil-soluble) component and a water-soluble component. The term "anionic surfactant" as used herein refers to a surfactant that contain anionic functional groups at their head, such as, but no limited to sulfate, sulfonate, phosphate, and carboxylates. In present invention it refers to ammonium lauryl sulfate, sodium lauryl sulfate (sodium dodecyl sulfate, SLS, or SDS), sodium octyl sulfate (SOS) and the related alkyl-ether sulfates sodium laureth sulfate (sodium lauryl ether sulfate or SLES), and sodium myreth sulfate. The term "cationic surfactant" as used herein refers to a surfactant that contain a cationic functional group at their head. In present invention it refers, but no limited to a quaternary ammonium salt, such as cetrimonium bromide (CTAB), cetylpyridinium chloride (CPC), benzalkonium chloride (BAC), benzethonium chloride (BZT), dimethyldioctadecylammonium chloride, and dioctadecyldimethylammonium bromide (DODAB).

A second aspect of the present invention relates to a method for obtaining the electrolyte-gated field-effect transistor of the present invention, characterized in that it comprises at least the following steps
a) defining the area for a source electrode and a drain electrode both by metal electrodes fabrication, on the surface of a substrate, and depositing a metal layer onto said defining area of the substrate to obtain said source and drain electrodes;
b) cleaning the substrate with the metallic electrodes obtained in step (a); and depositing a semiconductor layer;
c) immersing the transistor obtained in step (b) in surfactant aqueous solution during a time period of between 30 s and 12 h, wherein the concentration of surfactant is greater than the critical micelle concentration of the said surfactant, and drying the transistor;
d) depositing the dielectric layer on the transistor obtained in step (c) by dropping an electrolyte aqueous solution; and
e) connecting the third electrode with the dielectric layer deposited in step (d).

The term "critical micelle concentration" as used herein refers to the concentration of surfactants above which micelles form and all additional surfactants added to the system go to micelles. The micelles formed can then interact with the semiconductor.

The term "metal electrodes fabrication" as used herein refers to any technique which defines patterned electrodes. In the present invention it refers but not limited to, maskless laser photolithography, ink jet printing, screen printing, mask patterning and metal evaporation or sputtering.

In another preferred embodiment of the method of the present invention, it further comprises a modification of the surface of the source and drain electrodes with a self-assembled monolayer of an organic molecule after the cleaning in step (b) and before depositing the semiconductor layer in order to promote the formation of more homogenous or crystalline films. In a more preferably embodiment, self-assembled monolayer is pentafluorothiophenol (PFBT).

In another preferred embodiment of the method of the present invention, the metal layer of step a) is selected from of Cr, Au, Pt, Ti, Ag and any combination thereof.

In another preferred embodiment of the method of the present invention, the deposition of the semiconductor in step (b) is realized by Bar-Assisted Meniscus Shearing technique which is a solution-based deposition technique compatible with roll-to-roll printing processes and, thus, compatible with upscaling.

In another preferred embodiment of the method of the present invention, the surfactant is sodium dodecyl sulfate and wherein the concentration of surfactant aqueous solution is above 10 mM but below 1 M.

A third aspect of the invention refers to the use of the electrolyte-gated field-effect transistor described before in the present invention as transistor in portable sensor, disposable sensor, point-of-care devices and point-of-need sensors. Thanks to the fact that the transistors work in aqueous media they can be adapted for bio-sensing or for the development of ion sensors in water.

A microfluidic device including an inlet and an outlet, each in fluid communication with a microchannel, the microfluidic device comprising the electrolyte-gated field-effect transistor described in the present invention wherein the electrolyte-gated field effect transistor is in fluid communication with the microchannel.

The term "microfluidic device" as used herein refers to an EGFET device with chambers or channels that can be made of different materials such as plastic, glass or silicon, that geometrically constrain the aqueous electrolyte solution on the device. Unless otherwise defined, all technical and scientific terms used herein have the same meaning as commonly understood by one of ordinary skilled in the art to which this invention belongs. Methods and materials similar or equivalent to those described herein can be used in the practice of the present invention. Throughout the description and claims the word "comprise" and its variations are not intended to exclude other technical features, additives, components, or steps. Additional objects, advantages and features of the invention will become apparent to those skilled in the art upon examination of the description or may be learned by practice of the invention.

The following examples and drawings are provided by way of illustration and are not intended to be limiting of the present invention.

### BRIEF DESCRIPTION OF THE DRAWINGS

FIG. 1. Scheme of substrate with the Source (S) and Drain (D) electrodes in lateral view.
FIG. 2. Scheme of substrate with the Source (S) and Drain (D) electrodes in frontal view.
FIG. 3. Scheme of substrate with the Source (S) and Drain (D) electrodes, and the semiconductor layer in lateral view.
FIG. 4. Scheme of substrate with the Source (S) and Drain (D) electrodes, the semiconductor layer, the pool containing the electrolyte and the gate electrode in isometric view.
FIG. 5. Scheme of the device connected to the Source Measure Units (SMU).
FIG. 6. Transfer characteristic I vs V wherein the second potential (drain potential, V_{DS}) is fixed at -0.1 V with the absence and presence of SDS as protective layer.
FIG. 7. Transfer characteristic I vs V wherein the second potential (drain potential, V_{DS}) is fixed at -0.4 V with the absence and presence of SDS as protective layer.
FIG. 8. Graph representation of I vs t fixing V_{GS} at -0.4 V and V_{DS} at -0.05 V in presence and absence of the protective layer (SDS) normalized with I_{DS} max.
FIG. 9. Graph representation of I vs t fixing V_{GS} at -0.4 V and V_{DS} at -0.05 V in presence and absence of the protective layer (SDS).
FIG. 10. Transfer characteristic I vs V wherein the second potential (drain potential, V_{DS}) is fixed at -0.1 V with the absence and presence of SOS as protective layer.
FIG. 11. Transfer characteristic I vs V wherein the second potential (drain potential, V_{DS}) is fixed at -0.4 V with the absence and presence of SOS as protective layer.
FIG. 12. Graph representation of I vs t fixing V_{GS} at -0.4 V and V_{DS} at -0.05 V in presence and absence of the protective layer (SOS) normalized with I_{DS} max.
FIG. 13. Graph representation of I vs t fixing V_{GS} at -0.4 V and V_{DS} at -0.05 V in presence and absence of the protective layer (SOS).
FIG. 14. Transfer characteristic I vs V_{G} wherein the second potential (drain potential, V_{DS}) is fixed at 0.5 V in absence of CTAB as protective layer recorded before and after the I-t monitoring.
FIG. 15. Transfer characteristic I vs V_{GS} wherein the second potential (drain potential, V_{DS}) is fixed at 0.5 V in the presence of CTAB as protective layer recorded before and after the I-t monitoring.
FIG. 16. Graph representation of I vs t fixing V_{GS} at 0.4 V and V_{DS} at 0.3 V in presence and absence of the protective layer (CTAB) normalized with I_{DS} max.
FIG. 17. Graph representation of I vs t fixing V_{GS} at 0.4 V and V_{DS} at 0.3 V in presence and absence of the protective layer (CTAB).

### EXAMPLES

### Example 1

### Fabrication protocol of the Field effect transistor with diF-TES-ADT as p-type organic semiconductor and SDS as surfactant layer.

The substrate can be either flexible or rigid; our device fabrication protocol has been tested on two different substrates, namely a semi-transparent biocompatible Kapton foil (Kapton® HN from DuPont, 75 µm thick) or a Si/SiO₂ substrate (SiO₂ 200 nm thick). Source and drain (S/D) electrodes were defined by maskless laser photolithography. Briefly, a positive photoresist is spin casted on the substrate which is subsequently baked for 1 min at 75 °C in order to ensure the hardening of the resin. The desired device geometry is then patterned through positive photolithography (laser 385 nm) and the sample is then immersed for 2 minutes in the developer bath.

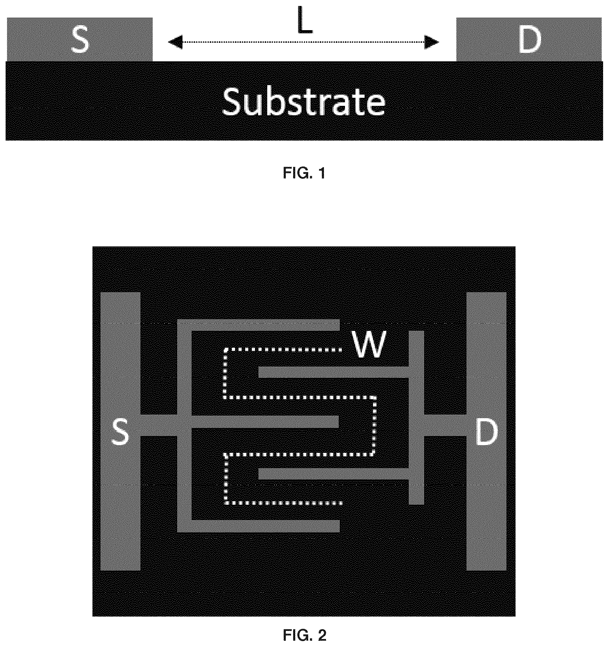

A metal layer of Cr/Au (5 nm/40 nm) is deposited through thermal evaporation to define the Source (S) and Drain (D) electrodes. The channel width (W) and length (L) were 19680 µm and 30 µm (namely having a geometrical ratio W/L = 656), respectively (see Figure 1,2 and 3 for details).

Prior to the deposition of the soluble organic semiconductor (OSC), the substrates were cleaned in ultrasonic bath with acetone and isopropanol for 15 min respectively and afterwards ozone-treated for 25 min. S/D electrodes were subsequently modified by immersing the device in a 15 mM pentafluorothiophenol (PFBT) solution in isopropanol for 15 minutes.

A blend composed of the p-type organic semiconductor 2,8-Difluoro-5,11-bis(triethylsilylethynyl)anthradithiophene (diF-TES-ADT) and the insulating polymer polystyrene Mw= 10000 g/mol was chosen as semiconductor ink solution. The blend solution was kept on a hot-plate at 105 °C for 1 h to ensure the complete dissolution of the starting materials. Thin layer deposition was realized through Bar-Assisted Meniscus Shearing (BAMS) technique by means of a home-adapted bar coater working at fixed speed of 1 cm s-1 and at a fixed plate temperature of 105 °C.
All the above-mentioned processes were realized under ambient conditions.

Sodium dodecyl sulfate (SDS) solution was prepared by dissolving the compound in MilliQ water reaching a final concentration of 50 mM. The solution was then stirred until complete dissolution of the molecule. The device was immersed in the SDS solution for 20 minutes to ensure the formation of the protective layer and then dried by N₂ gas.

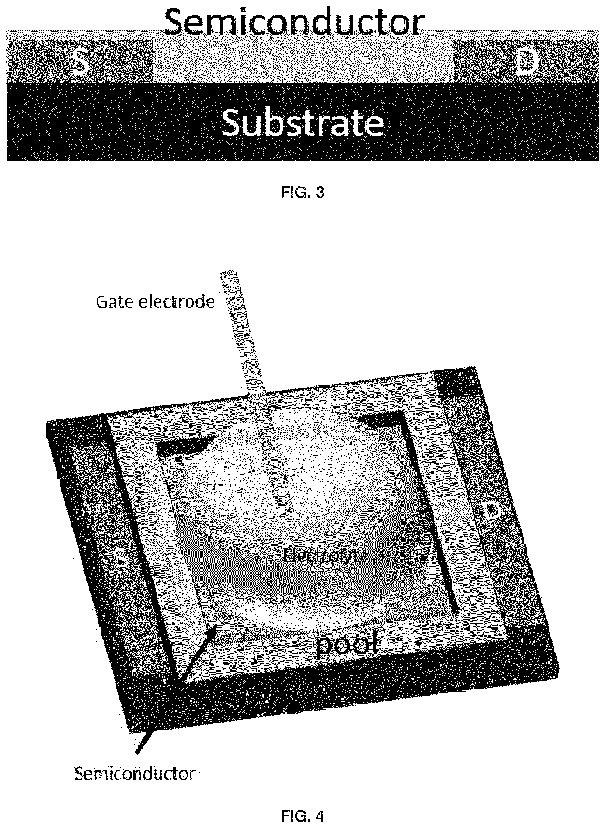

A plastic pool, polymeric organosilicon, is placed on top of the device for confining the working electrolyte on the active region of the device, and the gold gate electrode was then immersed in the working electrolyte (figure 4).

### Example 2

### The electrical characterization of the device of example 1

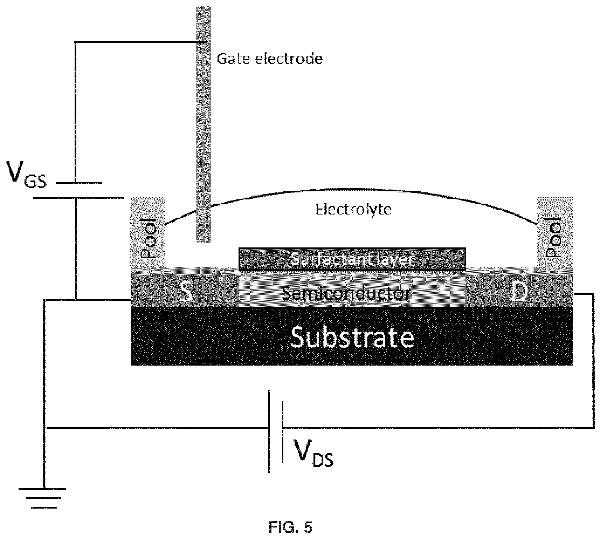

The device was connected to the Source Measure Units (SMU) according to the schematic of Figure 5.

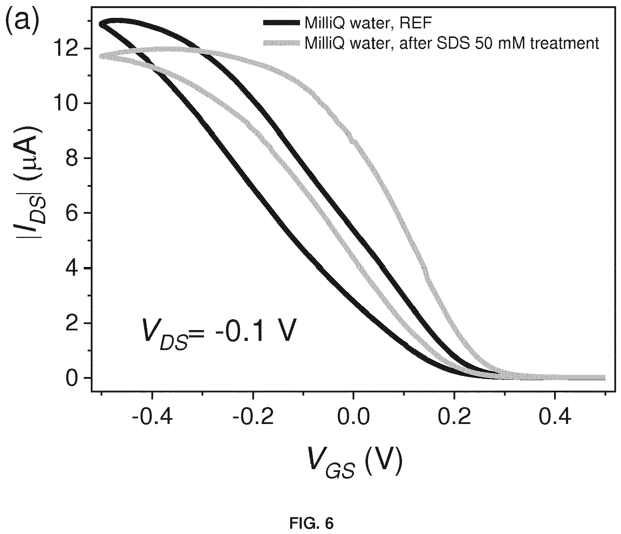

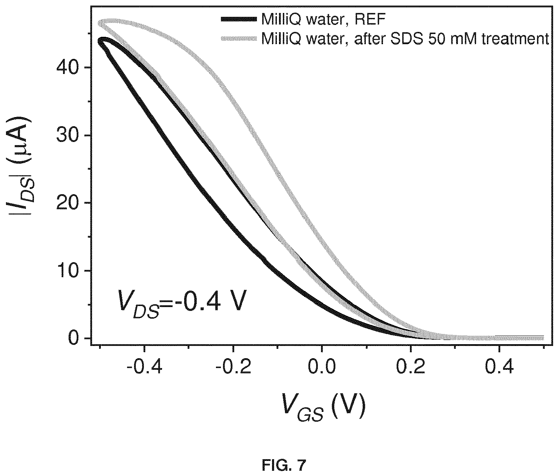

A transfer characteristic l/V was recorded as preliminary test which consisted in sweeping the gate potential (V_{GS}) from 0.5 V to -0.5 V. The second potential (drain potential, V_{DS}) was fixed at -0.1 V (**Figure 6****,** linear regime) or -0.4 V (**Figure 7****,** saturation regime). Transfer characteristics recorded in linear (left plot) and saturation (right plot) regimes. The black curves correspond to the device measured in absence of the protective coating (SDS) while the grey ones represent the response in presence of SDS as protective layer. The small shift of the curve is reasonable due to the negative charge of the surfactant which can dope the semiconductor layer.

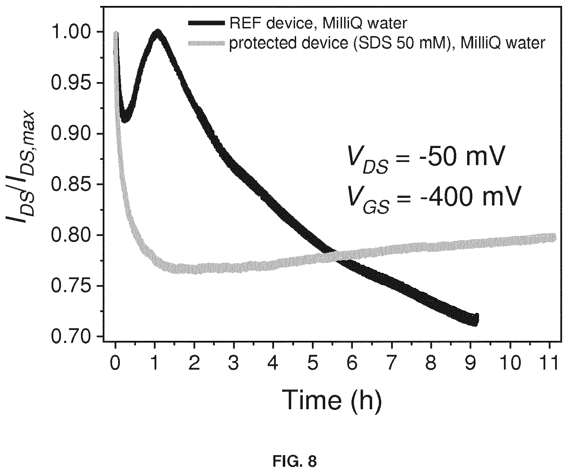

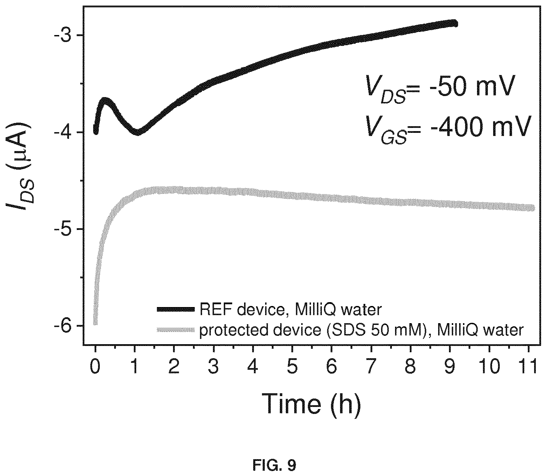

Then current monitoring I/t was performed (**Figure 8** and **Figure 9**) by fixing V_{GS} (-0.4 V) and V_{DS} (-0.05 V) and recording the current response *versus* time. I/t monitoring in presence (grey curve) and absence (black curve) of the protective layer (SDS). Despite the initial more pronounced initial current drop, the devices having the protection layer do not show any instability and the current remains constant for more than 11 hours. In absence of SDS the current slowly decreases while it is stable at 4.5 µA in the case of the protected device.

As it is possible to observe, the devices with SDS exhibited an enhanced stability and were stable for 12 hours.

### Example 3

### Fabrication protocol of the Field effect transistor with diF-TES-ADT as p-type organic semiconductor and Sodium octyl sulfate as surfactant layer.

A blend composed of the p-type organic semiconductor 2,8-Difluoro-5,11-bis(triethylsilylethynyl)anthradithiophene (diF-TES-ADT) and the insulating polymer polystyrene Mw= 10000 g/mol was chosen as semiconductor ink solution. The blend solution was kept on a hot-plate at 105 °C for 1 h to ensure the complete dissolution of the starting materials. Thin layer deposition was realized through Bar-Assisted Meniscus Shearing (BAMS) technique by means of a home-adapted bar coater working at fixed speed of 1 cm s⁻¹ and at a fixed plate temperature of 105 °C.
All the above-mentioned processes were realized under ambient conditions.
Sodium octyl sulfate (SOS) solution was prepared by dissolving the compound in MilliQ water reaching a final concentration of 150 mM. The solution was then stirred until complete dissolution of the molecule. The device was immersed in the SOS solution for 20 minutes to ensure the formation of the protective layer and then dried by N₂ gas.

A plastic, a polymeric organosilicon, pool is placed on top of the device for confining the working electrolyte on the active region of the device, and the gold gate electrode was then immersed in the working electrolyte.

### Example 4

### The electrical characterization of the device of example 3

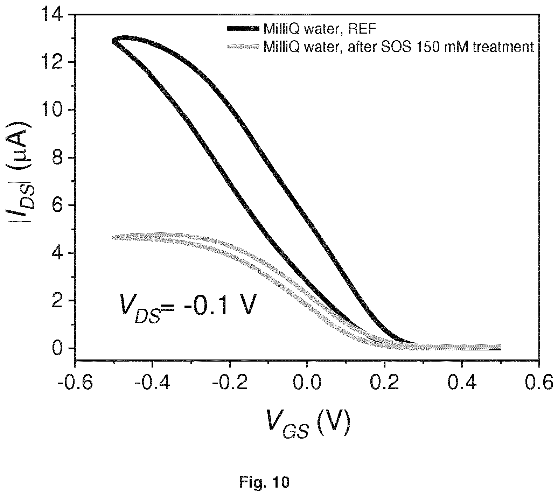

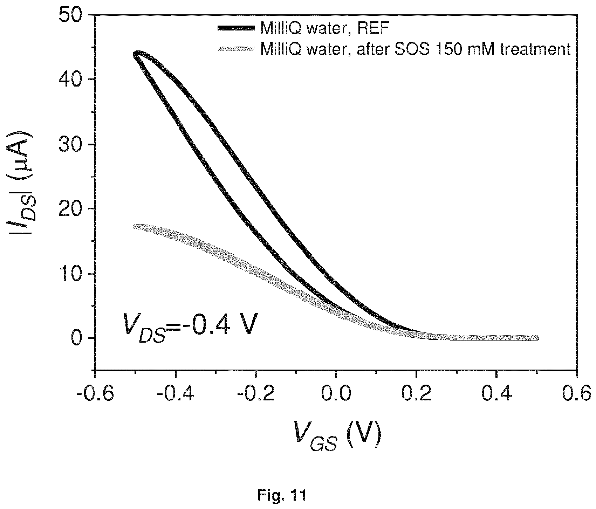

A transfer characteristic l/V (**Figure 10** and **Figure 11**) was recorded as preliminary test which consisted in sweeping the gate potential (V_{GS}) from 0.5 V to -0.5 V. The second potential (drain potential, V_{DS}) was fixed at -0.1 V (linear regime **Figure 10**) or - 0.4 V (saturation regime **Figure 11**). Transfer characteristics recorded in linear (left plot) and saturation (right plot) regimes. The black curves correspond to the device measured in absence of the protective coating (SOS) while the grey ones represent the response in presence of SOS as protective layer. The drop of the I_{DSmax} seems symptomatic of the presence of SOS which probably also penetrate inside the film partially decreasing its electrical performance. The SOS treatment contributes to a reduction of hysteresis.

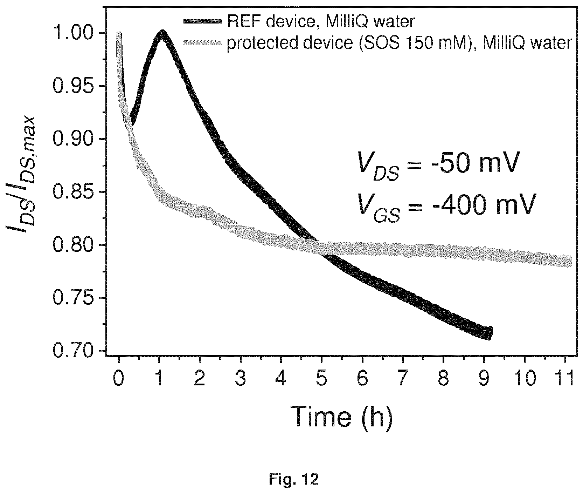

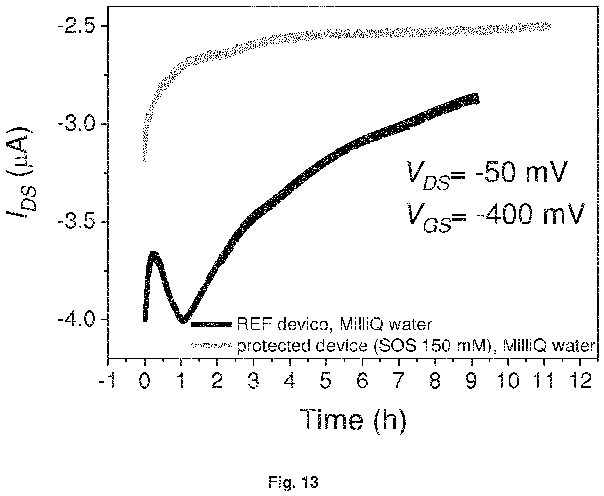

Then current monitoring I/t was performed (**Figure 12** and **Figure 13**) by fixing V_{GS} (-0.4 V) and V_{DS} (-0.05 V) and recording the current response *versus* time. I/t monitoring in presence (grey curve) and absence (black curve) of the protective layer (SOS). Despite the more pronounced initial current drop, the devices having the protection layer do not show any instability and the current remains constant for up to 11 hours. As it is possible to observe, the devices with SOS exhibited an enhanced stability and were stable up to 11 hours.

### Example 5

### Fabrication protocol of the Field effect transistor with PDI8CN2 as n-type organic semiconductor and hexadecyltrimethylammonium bromide (CTAB) as surfactant layer.

A blend composed of the organic semiconductor n-type N,N'-bis(n-octyl)-x:y,dicyanoperylene-3,4:9,10-bis(dicarboximide) (PDI8CN2) and the insulating polymer polystyrene Mw= 280000 g/mol was chosen as semiconductor ink solution. The blend solution was kept on a hot-plate at 105 °C for 1 h to ensure the complete dissolution of the starting materials. Thin layer deposition was realized through Bar-Assisted Meniscus Shearing (BAMS) technique by means of a home-adapted bar coater working at fixed speed of 1 cm s⁻¹ and at a fixed plate temperature of 105 °C.
All the above-mentioned processes were realized under ambient conditions.

Hexadecyltrimethylammonium bromide (CTAB) solution was prepared by dissolving the compound in MilliQ water reaching a final concentration of 10 mM. The solution was then stirred until complete dissolution of the molecule. The device was immersed in the CTAB solution for 20 minutes to ensure the formation of the protective layer and then dried by N₂ gas.

A plastic pool, a polymeric organosilicon is placed on top of the device for confining the working electrolyte on the active region of the device, and the gold gate electrode was then immersed in the working electrolyte.

### Example 6

### The electrical characterization of the device of example 5

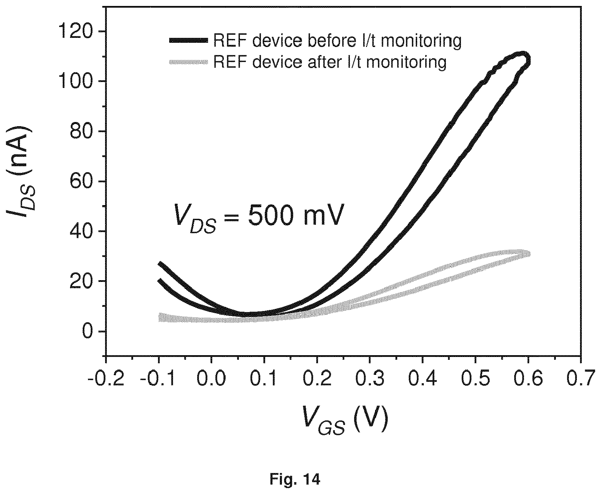

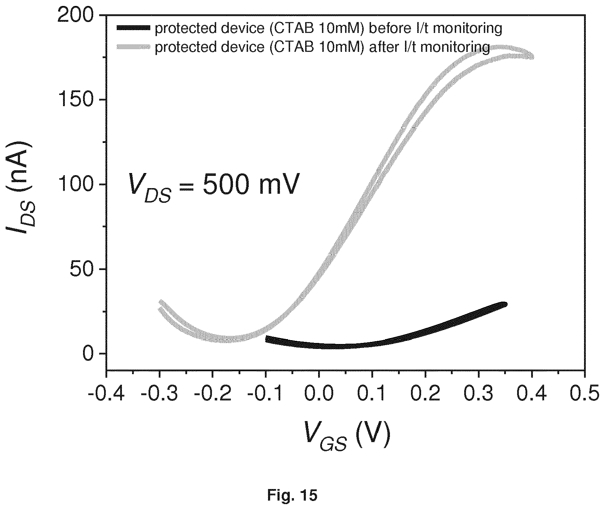

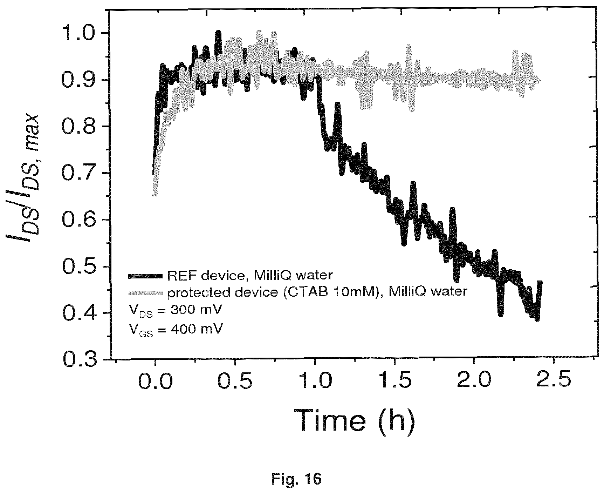

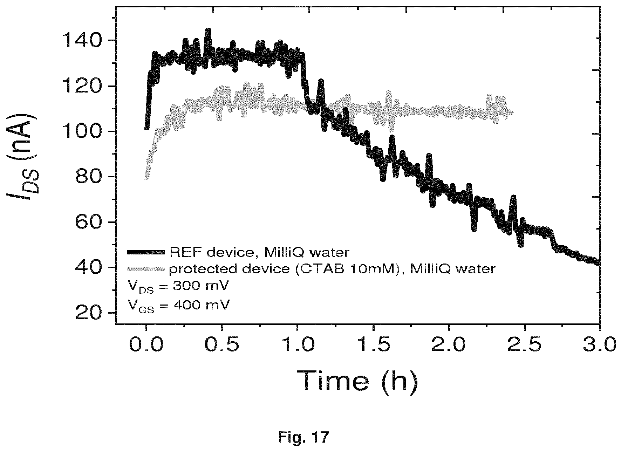

A transfer characteristic I/V (**Figure 14** **and** **Figure 15**) was recorded as preliminary test which consisted in sweeping the gate potential (V_{GS}) from -0.3 V to 0.4 V. The second potential (drain potential, V_{DS}) was fixed at 0.5 V (saturation regime). Transfer characteristics recorded in on the reference device (left plot) and for the CTAB-coated one (right plot). The black curves correspond to the device measured before the current monitoring while the grey ones represent the response after the I/t recording. Then current monitoring I/t was performed (normalized in **Figure 16** and **Figure** 17) by fixing V_{GS} (0.4 V) and V_{DS} (0.3 V) and recording the current response versus time. I/t monitoring in presence (grey curve) and absence (black curve) of the protective layer (CTAB).

The devices with CTAB exhibited an enhanced stability and were stable up to 2.5 hours. This is a n-channel device which is much less stable in air and especially in water. The current decreases observed for a reference device is absent in the device treated with CTAB which is stable up to 2.5
The deterioration of the device observed for the bare device (Figure 14) has an opposite trend in the case of the CTAB functionalized device which gain one order of magnitude in I_{DS} current (Figure 15)

## Claims

1. An electrolyte-gated field-effect transistor which comprises
• a substrate
• two metallic electrodes, one electrode configured to work as source electrode and the other electrode configured to work as drain electrode;
• at least one layer of a semiconductor as active material deposited on the substrate, contacting the two electrodes;
• a dielectric layer formed by an electrolyte aqueous solution;
• a third electrode in contact with the dielectric and configured to work as gate electrode, wherein preferably said gate electrode is formed by a conducting electrode selected from Au, Pt, glassy carbon and any combination thereof;
**characterized in that** the transistor further comprises a layer of a surfactant disposed between the semiconductor layer and the dielectric layer.

2. The transistor according to claim 1, wherein:
• the source electrode and the drain electrode are right above the substrate and the semiconductor is right above the substrate and the source electrode and the drain electrode, or
• the semiconductor is right above the substrate, and the source electrode and the drain electrode are right above the semiconductor layer.

3. The transistor according to any claims 1 or 2, wherein the layer of the surfactant has a thickness of between 1 nm and 100 nm.

4. The transistor according to any claims 1 to 3, wherein the substrate is selected from Si/SiO₂ substrate, polyethyleneterephtalate, polyethylene naphthalate, polyimide and any combination thereof, preferably the polyamide is poly-oxydiphenylene-pyromellitimide.

5. The transistor according to any claims 1 to 4, wherein the source or drain electrodes are formed by a metal selected from Cr, Au, Pt, Ti, Ag and any combination thereof.

6. The transistor according to any claims 1 to 5, wherein the semiconductor is an inorganic semiconductor selected from C, Si, Ge, Sn, B, Al, Ga, In, N, P, As, Sb, Bi, GaAs, AIGaAs, InGaAl, InSnO, ZnO, TiO₂, SrTiO₃, an amorphous oxide semiconductors and any combination thereof, preferably the amorphous oxide semiconductor is ZnSnO, InGaZnO or InZnO.

7. The transistor according to any claims 1 to 5, wherein the semiconductor is formed by at least one organic semiconductor selected from a p-type or n-type, preferably the p-type organic semiconductor is selected from the list comprising 2,8-Difluoro-5,11-bis(triethylsilylethynyl)anthradithiophene, 6,13-Bis(triisopropylsilylethynyl)pentacene, tetrathiafulvalene, [1]benzothieno[3,2-b][1]benzothiophene (BTBT) and any combination thereof; and the n-type organic semiconductor is selected from the list comprising N,N'-bis(n-octyl)-x:y,dicyanoperylene-3,4:9,10-bis(dicarboximide), PNDI(2OD)2T, fullerene and any combination thereof.

8. The transistor according to claim 7, wherein the semiconductor layer further comprises an insulating polymer selected from polystyrene, polymethylmetacrilate and any combination thereof which have a molecular weight of between 1000 g/mol and 300000 g/mol.

9. The transistor according to any claims 1 to 8, wherein further comprises a polymeric pool placed on the top of the surfactant layer, wherein said pool is configured to confining the dielectric layer formed by the electrolyte aqueous solution, preferably said polymeric pool is formed by a polymer selected from polydimethylsiloxane, any polymeric wax and any combination thereof.

10. The transistor according to any claims 1 to 9, wherein the surfactant is an anionic surfactant or cationic surfactant, preferably said anionic surfactant is selected from sodium dodecyl sulfate, sodium octyl sulfate, sodium nonanoyloxybenzenesulfonate and any combination thereof, and wherein said cationic surfactant is selected from hexadecyltrimethylammonium bromide, dimethyldioctadecylammonium bromide, C8-10 alkyl hydroxyethyl dimethylammonium chloride and any combination thereof.

11. The transistor according to claim 10, wherein the surfactant is sodium dodecyl sulfate.

12. A method for obtaining the electrolyte-gated field-effect transistor according to any claims 1 to 11, **characterized in that** it comprises the following steps
a) defining the area for a source electrode and a drain electrode both by metal electrodes fabrication, on the surface of a substrate, and depositing a metal layer onto said defining area of the substrate to obtain said source and drain electrodes;
b) cleaning the substrate with the metallic electrodes obtained in step (a); and depositing a semiconductor layer;
c) immersing the transistor obtained in step (b) in surfactant aqueous solution during a time period of between 30 s and 12 h, wherein the concentration of surfactant is greater than the critical micelle concentration of the said surfactant, and drying the transistor.
d) depositing the dielectric layer on the transistor obtained in step (c) by dropping an electrolyte aqueous solution; and
e) connecting the third electrode with the dielectric layer deposited in step (d).

13. The method according to claim 12, wherein the surfactant of step (c) is sodium dodecyl sulfate and wherein the concentration of surfactant aqueous solution is above 10 mM and below 1 M.

14. The method according to any claims 12 or 13, wherein further comprises a modification of the surface of the source and drain electrodes with self-assembled monolayer of an organic molecule after the cleaning and before depositing the semiconductor layer in step (b), preferably the organic molecule of the self-assembled monolayer is pentafluorothiophenol.

15. Use of the electrolyte-gated field-effect transistor according to any of claims 1 to 11 as transistor in portable sensor, disposable sensor, point-of-care devices and point-of-need sensors.
